# EUROPEAN PATENT APPLICATION

(11) **EP 4 658 003 A2**
(43) Date of publication of application: **03.12.2025**
(21) Application number: 25177607.6
(22) Date of filing: 20.05.2025
(51) Int. Cl.: H05K 1/14, H05K 3/00, H05K 3/46, H05K 1/02, H05K 1/11, H05K 3/40

(54) **LAMINATED SUBSTRATE AND METHOD OF MANUFACTURING LAMINATED SUBSTRATE**

(30) Priority: 30.05.2024 JP 2024087794
(71) Applicant: FICT LIMITED, Nagano-shi, Nagano 381-8501 (JP)
(72) Inventor: OZAKI, Norikazu, Nagano-shi, Nagano 381-8501 (JP); MIYAGAWA, Tetsurou, Nagano-shi, Nagano 381-8501 (JP); NAKAGAWA, Takashi, Nagano-shi, Nagano 381-8501 (JP); SAKAI, Naoki, Nagano-shi, Nagano 381-8501 (JP)
(74) Representative: Hoffmann Eitle

(57) **Abstract**

A laminated substrate (100) includes multilayer substrates (10) stacked, wherein the multilayer substrates (10) are each provided with a through hole (30) which penetrates the multilayer substrates (10), an inner wall surface of which is plated, and which is filled with resin (32), and bonding lands (34) formed on upper and lower surfaces of the through hole (30) and electrically coupled to the through hole (30), an insulating adhesive layer (40) and a conductive paste via (50) for electrically coupling the bonding lands (34) of the multilayer substrates (10) opposed to each other with a conductive paste with which a through hole (46) formed in the insulating adhesive layer (40) is filled are disposed between the multilayer substrates (10), and the conductive paste via (50) is disposed at a position different from a position at which the through hole (30) is formed.

## Description

### Technical Field

The present invention relates to a laminated substrate and a method of manufacturing a laminated substrate.

### Background Art

In the past, in order to compactly incorporate electronic components into an electronic device, circuit boards such as printed wiring boards have widely been used.

Meanwhile, in accordance with requirements such as a reduction in size, an increase in performance, and a reduction in price to the electronic device, miniaturization of an electronic circuit of a circuit board, an enhancement of multilayer, and an enhancement of high-density packaging of electronic components have rapidly advanced, and studies on the multilayer substrate obtained by providing a multilayer structure to the printed wiring board have been activated.

It should be noted that when providing through holes to the multilayer substrate, it is necessary to arrange that the larger the number of layers is, and the thicker the plate thickness is, the larger the diameter of a drill for boring the through holes is. Since this prevents the multilayer substrate from dealing with an increase in pitch, it has been studied that a multilayer substrate provided with the through holes formed with a drill having a diameter as thin as possible in a state in which the number of layers is not so large is prepared, and a plurality of such multilayer substrates is stacked on one another to finally obtain a multilayer laminated substrate.

For example, PTL 1 discloses a laminated substrate obtained by stacking an adhesive layer on an upper surface of one multilayer substrate, boring through holes in this adhesive layer, filling the through holes with a conductive paste, and stacking the other multilayer substrate on the adhesive layer and the conductive paste.

Further, the multilayer substrates are coupled using interlayer connection with through holes inner wall of which is plated, and a bonding land formed of a metal layer is formed as an upper surface and a lower surface of the through hole. The conductive paste described above is for electrically coupling the bonding lands to each other.

### Summary of Invention

### Technical Problem

PTL 1 described above discloses a configuration of electrically coupling the bonding lands of the through holes coupled using the interlayer connection penetrating the multilayer substrates with the conductive paste.

However, the inside of the through hole provided to each of the multilayer substrates is filled with resin in order to bond the layers constituting the multilayer substrate to each other. Therefore, when arranging the conductive paste immediately above the through hole, there is a problem that stress is applied to the conductive paste due to the thermal expansion of resin when the multilayer substrates are bonded to each other with thermocompression bonding, and thus, there is a possibility that long-term reliability of the conductive paste is inhibited.

### Solution to Problem

The present invention has been accomplished under the problem described above, and an object thereof is to provide a laminated substrate the long-term reliability of which can be ensured and a method of manufacturing the laminated substrate by preventing the stress from being applied to the conductive paste for achieving electrical coupling between a plurality of multilayer substrates when manufacturing the laminated substrate by stacking the plurality of multilayer substrates.

According to a laminated substrate related to the present invention, the laminated substrate includes a plurality of multilayer substrates stacked on one another, wherein each of the multilayer substrates is provided with a through hole which penetrates each of the multilayer substrates, an inner wall surface of which is plated, and an inside of which is filled with resin, and bonding lands which are formed on an upper surface and a lower surface of the through hole and which are electrically coupled to the through hole, an insulating adhesive layer and a conductive paste via configured to electrically couple the bonding lands of the multilayer substrates opposed to each other with a conductive paste with which a through hole formed in the insulating adhesive layer is filled are disposed between the multilayer substrates, and the conductive paste via is disposed at a position different from a position at which the through hole is formed.

By adopting this configuration, since the conductive paste via is disposed at a position different from that of the through hole, even when the resin in the through hole thermally expands, the conductive paste via is not applied with the stress due to the influence of the thermal expansion, and the long-term reliability can be maintained.

Further, as another feature, the plurality of conductive paste vias may be disposed at positions deviated from the through hole with respect to the set of bonding lands forming a pair.

According to this configuration, even when a relatively high current flows such as a case of a through hole for a power supply, the resistance value decreases since the plurality of conductive paste vias is disposed, and it is possible to prevent the amount of heat generation from increasing. By preventing the amount of heat generation from increasing, it is possible to eliminate the risk of fusing.

Further, as another feature, the bonding lands may be formed to have a size in which the plurality of conductive paste vias can be arranged.

Further, as another feature, the bonding lands may be formed to have a substantially quadrangular shape centering on the through hole so that the conductive paste vias are disposed at four places on a periphery centering on the through hole.

Further, as another feature, the bonding lands may have a substantially elliptical shape or a substantially oval shape which couples a position at which the conductive paste via is disposed and a position at which the through hole is disposed.

According to this configuration, it is possible to make the area of the bonding land as small as possible to reduce noise with respect to the through hole which requires protection against the noise such as a signal line.

Further, as another feature, the bonding lands may have a shape obtained by coupling a first circular portion surrounding the through hole and a second circular portion surrounding a position at which the conductive paste is disposed.

Also in the case of this configuration, it is possible to make the area of the bonding land as small as possible to reduce noise with respect to the through hole which requires protection against the noise such as a signal line.

According to a method of manufacturing a laminated substrate related to the present invention, the method of manufacturing the laminated substrate by stacking a plurality of multilayer substrates each provided with a through hole an inner wall surface of which is plated, and an inside of which is filled with resin, and bonding lands which are formed on an upper surface and a lower surface of the through hole and which are electrically coupled to the through hole includes a step of stacking an insulating adhesive layer on an upper surface of one of the multilayer substrates, a step of forming a through hole penetrating the insulating adhesive layer at a position different from a position at which the through hole is formed so as to electrically couple the bonding land of the one of the multilayer substrates and the bonding land of another of the multilayer substrates opposed to the one of the multilayer substrates, a step of filling the through hole with a conductive paste to form a conductive paste via, and a step of bonding the plurality of multilayer substrates with thermocompression bonding to cure the insulating adhesive layer and the conductive paste to thereby integrate the plurality of multilayer substrates.

According to this method, since the conductive paste via is disposed at a position different from that of the through hole, even when the resin in the through hole thermally expands, the conductive paste via is not applied with the stress due to the influence of the thermal expansion, and it is possible to obtain the laminated substrate the long-term reliability of which can be maintained.

Further, as another feature, before the step of stacking the insulating adhesive layer on the upper surface of the one of the multilayer substrates, there may be included a step of filling a recessed portion between the bonding land and another metal layer or another bonding land with insulating resin and grinding a surface to thereby perform planarization so as to eliminate asperity of a surface to be opposed to another of the multilayer substrates in the upper surface of the one of the multilayer substrates and the lower surface of the other of the multilayer substrates.

According to this method, it is possible to maintain the flatness of the laminated substrate to homogenize an electrical coupling layer with the conductive paste vias as a whole of the substrate to thereby prevent a resistance value abnormality from occurring.

### Advantageous Effects of Invention

According to the present invention, the long-term reliability can be ensured by preventing the stress from being applied to the conductive paste for achieving the electrical coupling between the plurality of multilayer substrates when manufacturing the laminated substrate by stacking the plurality of multilayer substrates.

### Brief Description of Drawings

Fig. 1 is a schematic cross-sectional view showing an example of a laminated substrate.
Fig. 2 is a schematic plan view of a bonding land showing an example of when a plurality of conductive paste vias is arranged with respect to one through hole.
Fig. 3 is a schematic plan view of a bonding land showing an example of when one conductive paste via is arranged with respect to one through hole.
Fig. 4 is a schematic cross-sectional view (number 1) showing an example of the method for manufacturing the multilayer substrate in the present embodiment.
Fig. 5 is a schematic cross-sectional view (number 2) showing an example of the method for manufacturing the multilayer substrate in the present embodiment.
Fig. 6 is a schematic cross-sectional view (number 3) showing an example of the method for manufacturing the multilayer substrate in the present embodiment.
Fig. 7 is a schematic cross-sectional view (number 4) showing an example of the method for manufacturing the multilayer substrate in the present embodiment.
Fig. 8 is a schematic cross-sectional view (number 5) showing an example of the method for manufacturing the multilayer substrate in the present embodiment.

### Description of Embodiments

### (Laminated Substrate)

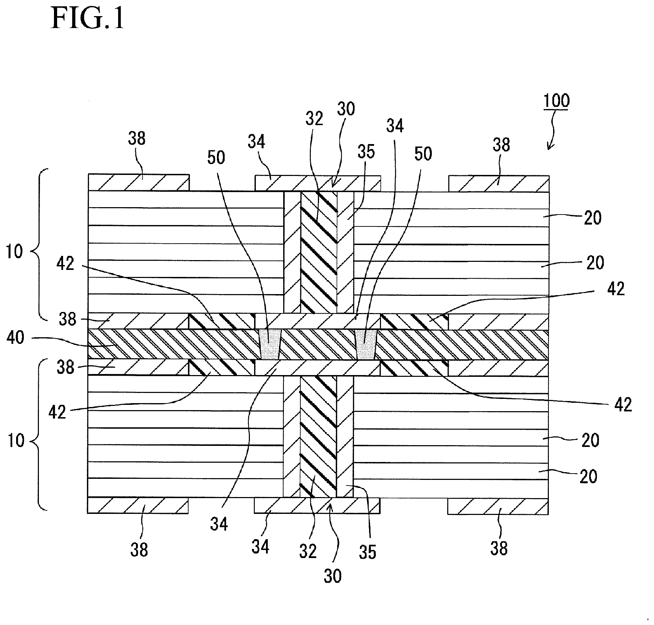

Some embodiments of the present invention will hereinafter be described based on the drawings. A schematic cross-sectional view of a laminated substrate is shown in Fig. 1.

It should be noted that in the present embodiments, an "upper surface" or a "lower surface" is described in some cases based on a vertical direction in the drawings for the sake of convenience, and the upper surface and the lower surface in the laminated substrate 100 or the multilayer substrate 10 include when the upper surface and the lower surface do not coincide with an actual vertical direction. Further, in the laminated substrate 100 or the multilayer substrate 10, a "side surface" is described in some cases, and the side surface means a side surface with reference to the upper surface and the lower surface described above.

The laminated substrate 100 shown in Fig. 1 is provided with a configuration in which, as an example, two multilayer substrates 10 are stacked in the vertical direction so as to electrically be coupled to each other, but is not limited to the stacking of the two multilayer substrates 10, and can be applied to stacking of two or more, that is a plurality of, multilayer substrates 10.

Further, the laminated substrate 100 shown in Fig. 1 describes when both are multilayer printed wiring boards (MLB) as an example.

Each of the multilayer substrates 10 has insulating layers 20 formed of a plurality of insulating base materials, and a metal layer (not shown) formed on an upper surface or a lower surface of each of the insulating layers 20, and is provided with a through hole 30 penetrating in a vertical direction.

The insulating layer 20 is not particularly limited as long as the insulating layer 20 is an insulating layer used in multilayer substrates, and can appropriately be selected for purposes. As an example, a base material reinforced in hardness with an inorganic base material such as inorganic woven cloth or inorganic unwoven cloth using glass cloth or the like, or an organic base material such as organic woven cloth or organic unwoven cloth can be adopted.

Further, more specifically, as an example, a glass epoxy base material (a glass woven base material impregnated with epoxy resin, a glass unwoven base material impregnated with epoxy resin), a glass woven base material impregnated with bismaleimide triazine resin, an aramid unwoven base material impregnated with epoxy resin, and a glass woven base material impregnated with modified polyphenylene ether resin can be adopted as the insulating layer 20.

The through hole 30 is provided with a plated layer 35 formed by applying plating with metal such as copper to an inner wall, and a hollow portion at an inner side of the plated layer 35 is filled with resin 32. The filling with the resin 32 is performed in order to bond the layers, which constitute each of the multilayer substrates, to each other so as not to separate from each other.

Bonding lands 34 to electrically be coupled to the through holes 30, a semiconductor element, and so on (not shown) of other multilayer substrates 10 are formed on the upper surface and the lower surface of each of the multilayer substrates 10 so as to close the through holes 30. The bonding land 34 is electrically coupled to the plated layer 35 of the through hole 30, and can be formed of metal such as copper.

An adhesive layer 40 intervenes between the multilayer substrates 10. As the adhesive layer 40, thermosetting resin can be adopted, and as an example, glass epoxy prepreg can be adopted.

The bonding land 34 on the upper surface of the multilayer substrate 10 at a lower side and the bonding land 34 on the lower surface of the multilayer substrate 10 at an upper side in Fig. 1 are electrically coupled with a via. This via is a conductive paste via 50 made of the conductive paste. As the conductive paste, what includes a conductive filler and binder resin can be adopted.

The conductive paste via 50 is disposed at a position different from the position of the through hole 30, that is, a position deviated from immediately above and immediately below the through hole 30. That is, the through holes 30 of the two multilayer substrates 10 are arranged in a straight line in the vertical direction, but the conductive paste via 50 is disposed at a position deviated from the straight line.

That is, when the conductive paste via 50 is disposed immediately above and immediately below the through hole 30, there is a possibility that the stress is applied to the conductive paste via 50 when the resin 32 located in the through hole 30 thermally expands due to the thermocompression bonding when bonding the multilayer substrates 10 to each other to inhibit the long-term reliability of the conductive paste via 50.

Therefore, by disposing the conductive paste via 50 at the position deviated from immediately above and immediately below the through hole 30 as described above, the stress due to the thermal expansion of the resin 32 in the through hole 30 is not applied to the conductive paste via 50, and thus, the long-term reliability can be ensured.

It should be noted that Fig. 1 illustrates a state in which the plurality of conductive paste vias with respect to one through hole 30, but the number of conductive paste vias 50 with respect to one through hole 30 is not limited to a certain number, and a single conductive paste via 50 or a plurality of conductive paste vias 50 can be provided with respect to one through hole 30.

Further, the arrangement positions of the conductive paste vias 50 are required to be distant from the resin 32 to the extent that the conductive paste vias 50 are not affected by the thermal expansion of the resin 32 located inside the through hole 30, and are appropriately set based on a type of the resin 32 and a diameter of the through hole 30.

Further, insulating resin 42 for planarizing the surfaces of the multilayer substrates 10 is arranged between the bonding land 34 on the upper surface of the multilayer substrate 10 at the lower side and a metal layer 38 adjacent thereto (or the bonding land located at a position adjacent thereto), and between the bonding land 34 on the lower surface of the multilayer substrate 10 at the upper side and the metal layer 38 adjacent thereto (or the bonding land 34 located at a position adjacent thereto).

That is, in the multilayer substrate 10, since the metal layer 38 including the bonding land 34 protrudes from the surface of the insulating layer 20 on the upper surface and the lower surface thereof, the insulating resin 42 is disposed in order to fill the gaps, and thus, the surfaces of the upper surface of the multilayer substrate 10 arranged at the lower side and the lower surface of the multilayer substrate 10 arranged at the upper side can be planarized.

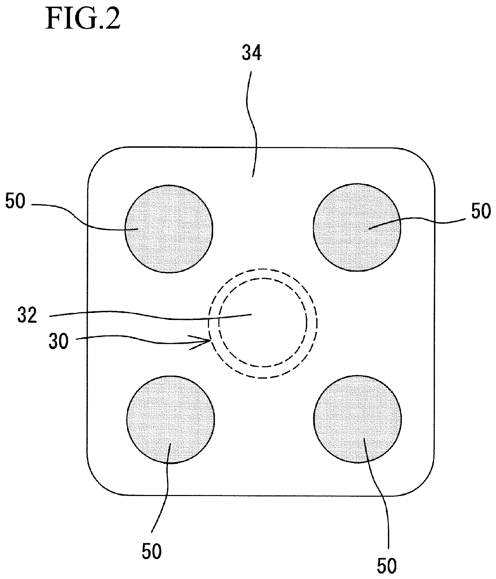

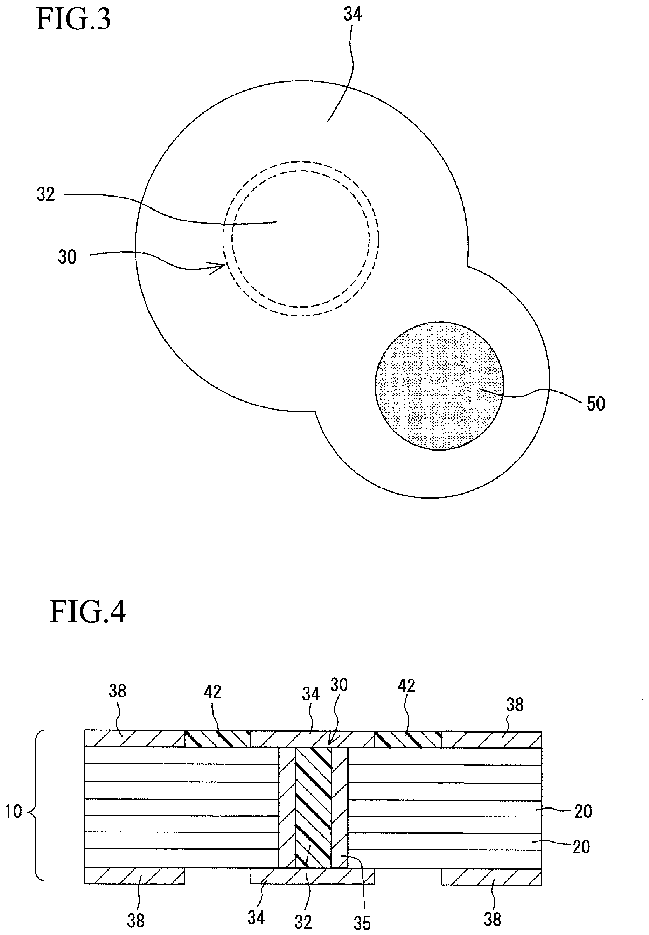

Fig. 2 and Fig. 3 show schematic plan views of a bonding land portion.

In the example shown in Fig. 2, there is adopted the bonding land 34 having a size enough to arrange the plurality of conductive paste vias 50 with respect to the bonding land 34 of one through hole 30. Specifically, a planar shape of the bonding land 34 is a substantially quadrangular shape. The through hole 30 is disposed at substantially the center of this quadrangular shape, and the conductive paste vias 50 are disposed at four places on the periphery of the through hole 30 (places corresponding to corners of the quadrangle).

It should be noted that in Fig. 2, the through hole 30 is illustrated with broken lines.

When the diameter of the through hole 30 is set to 250 µm, the diameter of the conductive paste via 50 is set to 180 µm, as one example, by setting the bonding land 34 to 720 µm on a side, it is possible to arrange the four conductive paste vias 50 with respect to one through hole 30 at positions not overlapping the through hole 30 within one bonding land 34.

It should be noted that the four conductive paste vias 50 with respect to the bonding land 34 of one through hole 30 in Fig. 2, but the number of conductive paste vias 50 is not limited to four, and two or three conductive paste vias 50 may be arranged.

Further, when a plurality of conductive paste vias 50 is arranged with respect to the bonding land 34 of one through hole 30, the planar shape of the bonding land 34 is not limited to the substantially quadrangular shape.

As shown in Fig. 2, as the case in which a plurality of conductive paste vias 50 is arranged with respect to the bonding land 34 of one through hole 30, the case in which a relatively high current flows such as the case of the through hole 30 for a power supply is conceivable as an example. By providing a plurality of conductive paste vias 50 with respect to the through hole 30 through which a high current flows, the resistance value becomes low, and it is possible to prevent an amount of heat generation from increasing. In this way, by preventing the amount of heat generation from increasing, it is possible to eliminate a risk of fusing at a location where the multilayer substrates 10 are stacked on one another.

Fig. 3 shows an example in which one conductive paste via 50 is arranged with respect to the bonding land 34 of one through hole 30.

The planar shape of the bonding land 34 in this case is a shape such as a gourd shape or a potbelly shape in which a large circle and a small circle partially overlap each other. Specifically, there is formed a shape in which a first circular portion 34a surrounding the through hole 30 and a second circular portion 34b surrounding the conductive paste via 50 are coupled to each other.

When the diameter of the through hole 30 is set to 250 µm and the diameter of the conductive paste via 50 is set to 180 µm as an example, it is possible to set the diameter of the first circular portion 34a to 500 µm, and the diameter of the second circular portion 34b to 340 µm.

As shown in Fig. 3, as the case in which one conductive paste via 50 is arranged with respect to the bonding land 34 of one through hole 30, the case of the through hole 30 which requires protection against noise such as a signal line is conceivable. In this case, an influence of noise becomes significant in some cases when the area of the bonding land 34 increases as shown in Fig. 2, and it is necessary to make the area of the bonding land 34 as small as possible.

Therefore, by providing a circular shape to each of the first circular portion 34a of the bonding land 34 to the through hole 30 and the second circular portion 34b of the bonding land 34 to the conductive paste via 50 so that the areas thereof can be made as small as possible, and adopting a shape obtained by partially overlapping these two circular portions 34a, 34b with each other, it is possible to eliminate a stub to decrease the influence of the noise.

It should be noted that the shape of the bonding land 34 when one conductive paste via 50 is arranged with respect to the bonding land 34 of one through hole 30 is not limited to the shape shown in Fig. 3, and may be a substantially elliptical shape or a substantially oval shape which couples a position where the through hole 30 is arranged and a position where the conductive paste via 50 is arranged to each other (not shown).

### (Method of Manufacturing Laminated Substrate)

Then, a method of manufacturing the laminated substrate will be described based on Fig. 4. It should be noted that the multilayer substrate 10 in Fig. 4 is the same as what is shown in Fig. **1****,** and a structure thereof will be denoted by the same reference numerals as those in Fig. 1 to omit the description thereof.

First, when stacking the multilayer substrates 10 on one another, in order to planarize the surface opposed to the other multilayer substrate 10 to be stacked, a recessed portion between the bonding land 34 and the metal layer 38 (or the other bonding land 34 adjacent there to) is filled with the insulating resin 42. Then, the insulating resin 42 is ground to be planarized so as to eliminate the asperity from the surface opposed to the other multilayer substrate 10. Thus, it is possible to maintain the flatness of the laminated substrate 100 to homogenize an electrical coupling layer with the conductive paste vias 50 as a whole of the substrate to thereby prevent a resistance value abnormality from occurring.

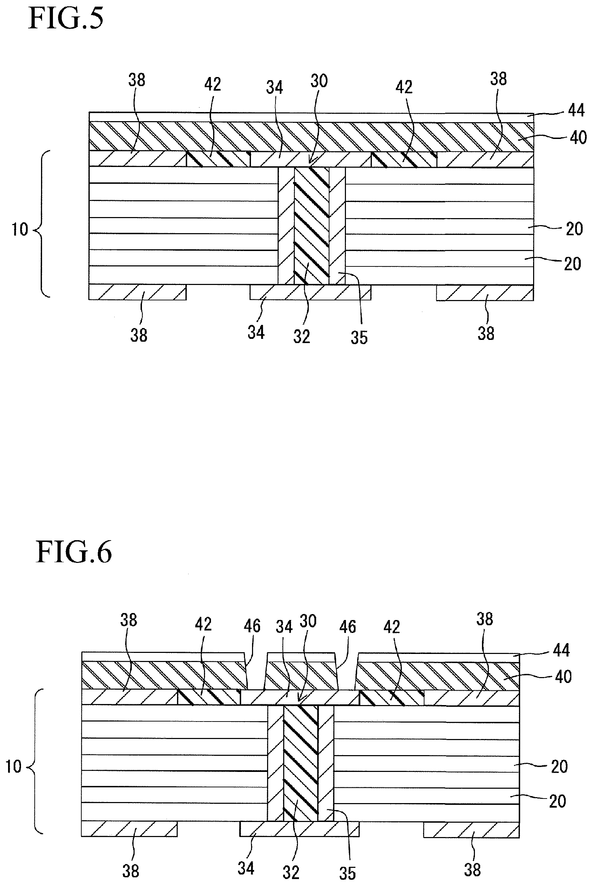

Then, as shown in Fig. 5, the adhesive layer 40 is stacked on the surface opposed to the other multilayer substrate 10 to be stacked. As described above, as the adhesive layer 40, thermosetting resin can be adopted, and as an example, glass epoxy prepreg can be adopted.

Further, a resin film 44 for protecting the surface of the adhesive layer 40 is stacked on the upper surface of the adhesive layer 40.

The adhesive layer 40 and the resin film 44 may be shaped like a sheet integrated in advance.

Then, as shown in Fig. 6, through holes 46 are provided to the adhesive layer 40 and the resin film 44.

The through hole 46 is a bottomed short hole which penetrates the adhesive layer 40 and the resin film 44, and takes the bonding land 34 as a bottom portion. The through holes 46 can be formed with laser processing as an example. As a type of the laser processing, CO2 laser, YAG laser, and so on can be cited, but these are not limitations, and the type of the laser processing can appropriately be selected for purposes.

It should be noted that here, since a plurality of conductive paste vias 50 is arranged with respect to the bonding land 34 of one through hole 30 as shown in Fig. 1, a plurality of through holes 46 is bored at positions which are different from the position where the through hole 30 is formed, and are deviated from immediately above the through hole 30.

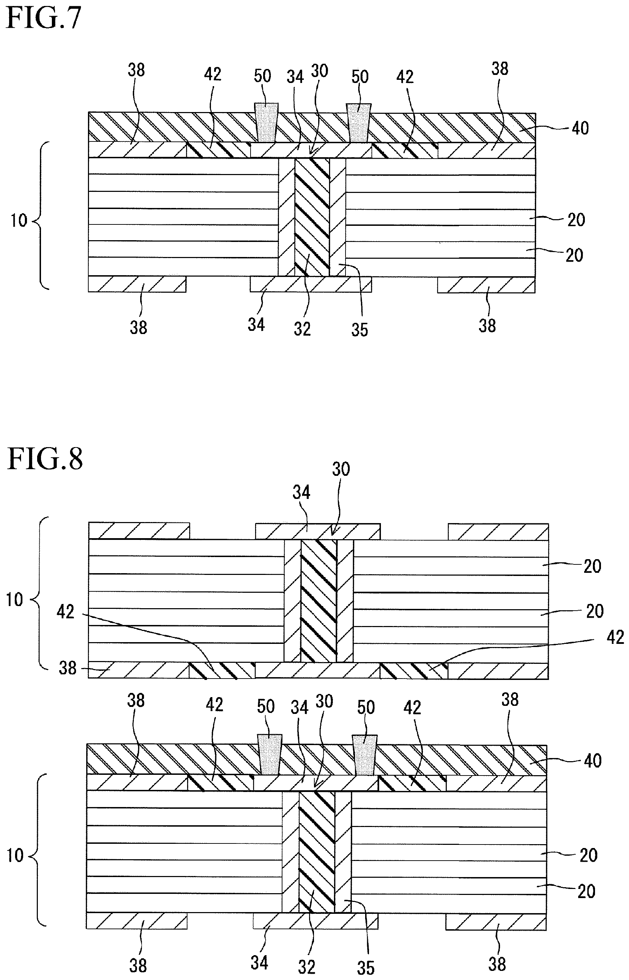

Then, as shown in Fig. 7, the through holes 46 are filled with the conductive paste, and then, the resin film 44 is separated.

Thus, the conductive paste vias 50 are formed, and further, by separating the resin film 44, the conductive paste protrudes upward from the adhesive layer 40 by the thickness of the resin film 44. Since the conductive paste protrudes from the adhesive layer 40, it is possible to reliably bond the conductive paste to the bonding land 34 of the other multilayer substrate 10.

Then, as shown in Fig. 8, the other multilayer substrate 10 is stacked on the multilayer substrate 10 provided with the adhesive layer 40 and the conductive paste vias 50. It should be noted that here, the lower surface of the other multilayer substrate 10 is planarized so as to eliminate the asperity by filling the recessed portions between the bonding lands 34 and the metal layer 38 (or other bonding lands 34 adjacent thereto) with the insulating resin 42.

Then, the multilayer substrates 10 are bonded to each other with thermocompression bonding. By performing the thermocompression bonding, the adhesive layer 40 and the conductive paste vias 50 are cured to form the laminated substrate 100 having the plurality of multilayer substrates 10 stacked on one another.

### (Other Embodiments of Laminated Substrate)

Regarding specific types of each of the multilayer substrates 10, constituting the laminated substrate 100, both the substrates may be the multilayer printed wiring boards (MLB) as shown in Fig. 1, or it is possible to use the multilayer printed wiring board (MLB) as the multilayer substrate 10 at the lower side and a semiconductor package substrate (PKG) as the multilayer substrate 10 at the upper side. Further, it is also possible to use the multilayer printed wiring board (MLB) as the multilayer substrate 10 at the lower side and a core-less semiconductor package substrate (CL) as the multilayer substrate 10 at the upper side. Further, it is also possible to adopt a configuration in which the multilayer substrates 10 as the core-less semiconductor package substrates (CL) are stacked on both the upper and lower surfaces of the multilayer substrate 10 at the lower side which is the multilayer printed wiring board (MLB).

The laminated substrate 100 in the present embodiment can be used as a motherboard (a support substrate), and can also be used as an interposer (a relay substrate). It can be used in particular as the motherboard or the interposer of a server system or a high-speed communication system, and can further be used as a circuit board constituting a semiconductor element. Further, it can also be applied to an inspection device, a probe card, and so on to be used for a quality determination of a semiconductor.

## Claims

1. A laminated substrate (100) comprising:
a plurality of multilayer substrates (10) stacked on one another, wherein
each of the multilayer substrates (10) is provided with a through hole (30) which penetrates each of the multilayer substrates (10), an inner wall surface of which is plated, and an inside of which is filled with resin (32), and bonding lands (34) which are formed on an upper surface and a lower surface of the through hole (30) and which are electrically coupled to the through hole (30),
an insulating adhesive layer (40) and a conductive paste via (50) configured to electrically couple the bonding lands (34) of the multilayer substrates (10) opposed to each other with a conductive paste with which a through hole (46) formed in the insulating adhesive layer (40) is filled are disposed between the multilayer substrates (10), and
the conductive paste via (50) is disposed at a position different from a position at which the through hole (30) is formed.

2. The laminated substrate (100) according to claim 1, wherein
a plurality of the conductive paste vias (50) is disposed at positions different from the position at which the through hole (30) is formed with respect to the set of bonding lands (34) forming a pair.

3. The laminated substrate (100) according to claim 2, wherein
the bonding lands (34) are formed to have a size enough to arrange the plurality of conductive paste vias (50).

4. The laminated substrate (100) according to claim 3, wherein
the bonding lands (34) are formed to have a substantially quadrangular shape centering on the through hole (30) so that the conductive paste vias (50) are disposed at four places on a periphery centering on the through hole (30).

5. The laminated substrate (100) according to claim **1,** wherein
the bonding lands (34) have a substantially elliptical shape or a substantially oval shape which couples a position at which the conductive paste via (50) is disposed and a position at which the through hole (30) is disposed.

6. The laminated substrate (100) according to claim **1,** wherein
the bonding lands (34) have a shape obtained by coupling a first circular portion (34a) surrounding the through hole (30) and a second circular portion (34b) surrounding a position at which the conductive paste is disposed.

7. A method of manufacturing a laminated substrate (100) by stacking a plurality of multilayer substrates (10) each provided with a through hole (30) an inner wall surface of which is plated, and an inside of which is filled with resin (32), and bonding lands (34) which are formed on an upper surface and a lower surface of the through hole (30) and which are electrically coupled to the through hole (30), the method comprising:
a step of stacking an insulating adhesive layer (40) on an upper surface of one of the multilayer substrates (10);
a step of forming a through hole (46) penetrating the insulating adhesive layer (40) at a position different from a position at which the through hole (30) is formed so as to electrically couple the bonding land (34) of the one of the multilayer substrates (10) and the bonding land (34) of another of the multilayer substrates (10) opposed to the one of the multilayer substrates (10);
a step of filling the through hole (46) with a conductive paste to form a conductive paste via (50); and
a step of bonding the plurality of multilayer substrates (10) with thermocompression bonding to cure the insulating adhesive layer (40) and the conductive paste to thereby integrate the plurality of multilayer substrates (10).

8. The method of manufacturing the laminated substrate (100) according to claim 7, further comprising:
before the step of stacking the insulating adhesive layer (40) on the upper surface of the one of the multilayer substrates (10),
a step of filling a recessed portion between the bonding land (34) and another metal layer (38) or another bonding land (34) with insulating resin (42) and grinding a surface to thereby perform planarization so as to eliminate asperity of a surface to be opposed to another of the multilayer substrates (10) in the upper surface of the one of the multilayer substrates (10) and the lower surface of the other of the multilayer substrates (10).
